# EUROPEAN PATENT SPECIFICATION

(11) **EP 3 406 684 B1**
(45) Date of publication and mention of the grant of the patent: **06.09.2023**
(21) Application number: 16886507.9
(22) Date of filing: 16.12.2016
(51) Int. Cl.: C09G 1/04, C09K 3/14, B24B 37/04, B24B 37/00, C09G 1/02, H01L 21/304

(54) **POLISHING COMPOSITION AND METHOD FOR POLISHING SILICON SUBSTRATE**
POLIERZUSAMMENSETZUNG UND VERFAHREN ZUM POLIEREN EINES SILICIUMSUBSTRATS
COMPOSITION DE POLISSAGE ET PROCÉDÉ DE POLISSAGE D'UN SUBSTRAT EN SILICIUM

(30) Priority: 19.01.2016 JP 2016007810
(43) Date of publication of application: 28.11.2018
(73) Proprietor: Fujimi Incorporated, Nishikasugai-gun, Aichi 452-8502 (JP)
(72) Inventor: TSUCHIYA, Kohsuke, Kiyosu-shi, Aichi 452-8502 (JP); ICHITSUBO, Taiki, Kiyosu-shi, Aichi 452-8502 (JP); TANSHO, Hisanori, Kiyosu-shi, Aichi 452-8502 (JP); SUGA, Yusuke, Kiyosu-shi, Aichi 452-8502 (JP)
(74) Representative: Grünecker Patent- und Rechtsanwälte PartG mbB
(86) International application number: PCT/JP2016/087604
(87) International publication number: WO 2017/126268

(56) References cited:
- EP-A1- 2 960 314
- WO-A1-2014/030570
- WO-A1-2014/148399
- WO-A1-2014/148399
- WO-A1-2014/196299
- WO-A1-2014/196299
- WO-A1-2015/060293
- WO-A1-2015/060293
- WO-A1-2016/035346
- JP-A- 2000 313 815
- US-A1- 2015 210 891

## Description

### Technical Field

The present invention relates to a polishing composition and a method for polishing a silicon substrate.

### Background Art

In order to improve the quality, such as smoothing and a reduction in defects, of the surface of a silicon wafer, various techniques relating to a polishing composition or a polishing method have been proposed (see Patent Document 1) . However, in recent years, the required level for the surface quality of a silicon wafer has increasingly become higher, and therefore these techniques have been required to be further improved.

### Citation list

### Patent literature

PTL 1: WO 2014/148399
PTL 2: WO 2014/148399 A1
PTL 3: EP 2 960 314 A1

EP 2 960 314 A1 discloses a polishing composition comprising: colloidal silica of 25nm and 46nm for the average primary and secondary particle diameter, PVA-A and PACMO-A as water-soluble polymer, wherein the weight average molecular weight of the water-soluble polymer is 13000, the content of water-soluble polymer is between 0.001% and 1% by mass, a basic compound selected from hydroxides or salts of alkali metals or alkaline-earth metals, quaternary ammonium hydroxides or salts thereof, ammonia or amine, and a content of the basic compound in the polishing composition is 0.0001% by mass or more and 1.0% by mass or less.

### SUMMARY OF THE INVENTION

### Technical Problem

It is an object of the present invention to solve the problems of the former techniques described above and provide a polishing composition and a method for polishing a silicon substrate capable of realizing a polished surface having high smoothness and few defects.

### Solution to Problem

In order to solve the above-described problems, a polishing composition according to one aspect of the present invention is a polishing composition containing abrasives and a water-soluble polymer, in which the water-soluble polymer satisfies the following two conditions (A) and (B):
Condition (A): in a first standard solution containing silica having an average primary particle size of 35 nm, the water-soluble polymer, ammonia, and water, in which the concentration of the silica is 0.48% by mass, the concentration of the water-soluble polymer is 0.0125% by mass, and the pH is 10.0, the adsorption ratio defined as a ratio of the amount of the water-soluble polymer adsorbed to the silica to the total amount of the water-soluble polymer contained in the first standard solution is 10% or more; and
Condition (B) : in a second standard solution containing silica having an average primary particle size of 35 nm, the water-soluble polymer, ammonia, and water and in which the concentration of the silica is 0.48% by mass, the concentration of the water-soluble polymer is 0.0125% by mass, and the pH is 10.4, the adsorption ratio defined as a ratio of the amount of the water-soluble polymer adsorbed to the silica to the total amount of the water-soluble polymer contained in the second standard solution is 65% or less.

A method for polishing a silicon substrate according to another aspect of the present invention includes polishing a silicon substrate using the polishing composition according to the above-described one aspect.

### Advantageous Effects of Invention

The present invention can realize a polished surface having high smoothness and few defects.

### Description of Embodiments

One embodiment of the present invention will now be described in detail. A polishing composition according to this embodiment is a polishing composition containing abrasives and a water-soluble polymer, in which the water-soluble polymer satisfies the following two conditions (A) and (B):
Condition (A) : in a first standard solution containing silica having an average primary particle size of 35 nm, the water-soluble polymer, ammonia, and water, in which the concentration of the silica is 0.48% by mass, the concentration of the water-soluble polymer is 0.0125% by mass, and the pH is 10.0, the adsorption ratio defined as a ratio of the amount of the water-soluble polymer adsorbed to the silica to the total amount of the water-soluble polymer contained in the first standard solution is 10% or more; and
Condition (B) : in a second standard solution containing silica having an average primary particle size of 35 nm, the water-soluble polymer, ammonia, and water, in which the concentration of the silica is 0.48% by mass, the concentration of the water-soluble polymer is 0. 0125% by mass, and the pH is 10.4, the adsorption ratio defined as a ratio of the amount of the water-soluble polymer adsorbed to the silica to the total amount of the water-soluble polymer contained in the second standard solution is 65% or less.

In other words, when the first standard solution and the second standard solution containing the water-soluble polymer are prepared, and then the adsorption ratio to the silica of the water-soluble polymer in the first standard solution and the second standard solution is within the numerical values of the condition (A) and the condition (B) above, the water-soluble polymer can be used as the water-soluble polymer to be contained in the polishing composition of this embodiment.

Such a polishing composition of this embodiment can be preferably used for polishing various objects to be polished, such as simple substance silicon, a silicon compound, metal, and ceramics, and can realize a polished surface having high smoothness (low haze) . Moreover, a polished surface with few defects is realizable. In particular, when the polishing composition of this embodiment is used for polishing a silicon substrate, a silicon substrate, such as a silicon single crystal substrate, having high surface smoothness and few defects can be produced.

Hereinafter, the polishing composition of this embodiment is described in detail. Various operations and measurement of physical properties described below are performed under the conditions of room temperature (20°C or more and 25°C or less) and relative humidity of 40% or more and 50% or less insofar as unless otherwise particularly specified.

### 1. Adsorption ratio

The adsorption ratio in this embodiment is the percentage of the amount of the water-soluble polymer adsorbed to the silica to the total amount of the water-soluble polymer contained in the first standard solution or the second standard solution. In detail, the adsorption ratio in this embodiment is a ratio (percentage) of the amount of the water-soluble polymer adsorbed to the silica of the total amount of the water-soluble polymer contained in the first standard solution or the second standard solution.

In the case of the polishing composition containing the water-soluble polymer having the characteristics satisfying the condition (A), a polished surface having high smoothness (low haze) and few defects can be realized when used for polishing an object to be polished.

It is considered that, when the amount of the water-soluble polymer adsorbed to the abrasives is large in polishing the surface to be polished of an object to be polished using the polishing composition of this embodiment, the surface of the abrasives is protected by the water-soluble polymer and a processing load to be applied to the surface to be polished of the object to be polished decreases, and therefore a polished surface having high smoothness (low haze) and few defects is likely to be obtained. The pH of the polishing composition in the polishing is usually about 10.0, and therefore the numerical value of the adsorption ratio when the pH is 10.0 serves as an index.

The adsorption ratio when the pH is 10.0 is 10% or more, preferably 20% or more, and more preferably 50% or more. The adsorption ratio when the pH is 10.0 is preferably 80% or less and more preferably 70% or less. When the adsorption ratio at a pH of 10.0 is as described above, an effect that appropriate protectivity of a polished surface is obtained is demonstrated.

On the other hand, in the case of the polishing composition containing the water-soluble polymer having the characteristics satisfying the condition (B), when an object to be polished after polishing to which the polishing composition adheres is cleaned, a polished surface with few defects can be realized.

It is considered that, when the amount of the water-soluble polymer adsorbed to the abrasives is small due to the desorption of the water-soluble polymer from the abrasives in the cleaning of the object to be polished after the polishing, the abrasives are likely to be cleaned from the object to be polished, and therefore defects are hard to occur in the polished surface of the object to be polished in the cleaning. The pH (pH in a state where a cleaning liquid is mixed, for example) of the polishing composition in the cleaning is usually about 10.4, and therefore the numerical value of the adsorption ratio when the pH is 10.4 serves as an index.

The adsorption ratio when the pH is 10.4 is 65% or less or less than the adsorption ratio when the pH is 10.0 described above and 65% or less, preferably 50% or less or less than the adsorption ratio when the pH is 10.0 described above and 50% or less, more preferably 40% or less or less than the adsorption ratio when the pH is 10.0 described above and 40% or less, and still more preferably 30% or less or less than the adsorption ratio when the pH is 10. 0 described above and 30% or less.

### 2. Abrasives

The type of the abrasives contained in the polishing composition of this embodiment is not particularly limited and, for example, inorganic particles, organic particles, organic-inorganic composite particles, and the like are usable as the abrasives. Specific examples of the inorganic particles include particles containing metal oxides, such as silica, alumina, ceria, and titania, and particles containing ceramics, such as silicon nitride, silicon carbide, and boron nitride. Specific examples of the organic particles include polymethyl methacrylate (PMMA) particles. Among the above, silica is preferable. Specific examples of the silica include colloidal silica, fumed silica, precipitated silica, and the like and colloidal silica is particularly preferable. The abrasives may be used alone or in combination of two or more kinds thereof.

The average primary particle size of the abrasives is not particularly limited and may be set to 100 nm or less, preferably 50 nm or less, more preferably 40 nm or less, and still more preferably 30 nm or less. When the average primary particle size of the abrasives is within the ranges mentioned above, an effect that the smoothness of a polished surface is improved is demonstrated. On the other hand, the average primary particle size of the abrasives may be set to 5 nm or more, preferably 10 nm or more, and more preferably 20 nm or more. When the average primary particle size of the abrasives is within the ranges mentioned above, an effect that the polishing removal rate of an object to be polished by the polishing composition is improved is demonstrated. The average primary particle size of the abrasives can be calculated from the specific surface area measured by a nitrogen adsorption process (BET method), for example.

The average secondary particle size of the abrasives is not particularly limited and may be set to 150 nm or less, preferably 100 nm or less, more preferably 80 nm or less, and still more preferably 60 nm or less. When the average secondary particle size of the abrasives is within the ranges mentioned above, an effect that the smoothness of a polished surface is improved is demonstrated. On the other hand, the average secondary particle size of abrasives may be set to 10 nm or more, preferably 20 nm or more, more preferably 30 nm or more, and still more preferably 40 nm or more. When the average secondary particle size of the abrasives is within the ranges mentioned above, an effect that polishing can be performed in a short time is demonstrated. The average secondary particle size of the abrasives can be measured by a dynamic light scattering method using UPA-UT151 manufactured by Nikkiso Co., Ltd., for example.

The content of the abrasives in the polishing composition of this embodiment may be set to 0.01% by mass or more, preferably 0.05% by mass or more, more preferably 0.10% by mass or more, and still more preferably 0.15% by mass or more. When the content of the abrasives is within the ranges mentioned above, an effect that the polishing removal rate of an object to be polished by the polishing composition is improved is demonstrated. On the other hand, the content of the abrasives may be set to 3.0% by mass or less, preferably 1. 0% by mass or less, more preferably 0.50% by mass or less, still more preferably 0.30% by mass or less, and yet still more preferably 0.20% by mass or less. When the content of the abrasives is within the ranges mentioned above, the dispersion stability of the polishing composition is improved.

### 3. Water-soluble polymer

To the polishing composition of this embodiment, the water-soluble polymer (which may be a copolymer or a salt or a derivative thereof) satisfying the conditions of the adsorption ratio to the abrasives described above is added. The water-soluble polymer improves the protectivity of the surface of the abrasives and the polished surface and the wettability of the polished surface.

As the water-soluble polymer, those having at least one kind of functional groups selected from a cationic group, an anionic group, and a nonionic group in the molecules are usable. Specifically, those having a hydroxyl group, a carboxyl group, an acyloxy group, a sulfo group, an amide group, an amidino group, an imino group, an imide group, a quaternary nitrogen structure, a heterocyclic structure containing the functional group unit mentioned above, a vinyl structure, a polyoxyalkylene structure, and the like in the molecules are all usable.

Specific examples of the water-soluble polymer include a cellulose derivative, polyvinyl alcohol, poly(meth)acrylic acid, poly(meth)acrylamide alkylsulfonic acid, polyisoprene sulfonic acid, polyvinyl sulfonic acid, polyallyl sulfonic acid, polyisoamylene sulfonic acid, polystyrene sulfonic acid, poly(meth)acrylamide, polyalkylaminoalkyl (meth)acrylamide, polyvinyl pyrrolidone, a copolymer containing polyvinyl pyrrolidone in a part of the structure, polyvinyl caprolactam, a copolymer containing polyvinyl caprolactam in a part of the structure, polyalkoxyalkyl (meth)acrylamide, polyhydroxyalkyl (meth)acrylamide, poly(meth)acryloyl morpholine, polyamidine, polyethyleneimine, hydrophilized polyimide, various polyamino acids, imine derivatives, such as poly(N-acylalkyleneimine), a polyvinyl alcohol derivative in which a part of the hydroxyl group site of polyvinyl alcohol is substituted by a quaternary nitrogen structure, polymers having polyoxyethylene or polyoxyalkylene structure, polymers having a plurality of kinds of structures, such as a diblock type, a triblock type, a random type, and an alternate type thereof, and the like. The representation of the poly(meth)acrylic acid means acrylic acid and/or methacrylic acid and the same applies to the other compounds.

Among the water-soluble polymers mentioned above, the cellulose derivative, polyvinylalcohol, poly(meth)acryloyl morpholine, and the polymer having a polyoxyalkylene structure are preferable from the viewpoint of an improvement of wettability, prevention of adhesion of the particles, reduction in surface roughness, and the like of a polished surface of a substrate, such as a silicon wafer. Specific examples of the cellulose derivative include hydroxyethylcellulose, hydroxypropylcellulose, hydroxyethylmethylcellulose, hydroxypropylmethylcellulose, methylcellulose, ethylcellulose, ethylhydroxyethylcellulose, carboxymethylcellulose, and the like. Among the cellulose derivatives, hydroxyethylcellulose is particularly preferable in terms of the fact that the capability of imparting wettability to a polished surface of a substrate, such as a silicon wafer, is high and hydroxyethylcellulose has good cleaning properties. The water-soluble polymers may be used alone or in combination of two or more kinds thereof.

The weight average molecular weight of the water-soluble polymer is not particularly limited and may be set to 2 million or less, preferably 1 million or less, more preferably 500,000 or less, still more preferably 300,000 or less, still more preferably 200,000 or less, particularly preferably 100,000 or less, and most preferably 50,000 or less. When the weight average molecular weight is within the ranges mentioned above, effects that the stability of the polishing composition is improved and defects of an object to be polished decrease are demonstrated.

On the other hand, the weight average molecular weight of the water-soluble polymer may be set to 1000 or more, preferably 5000 or more, and more preferably 10,000 or more. When the weight average molecular weight is within the ranges mentioned above, an effect that the polishing removal rate of an object to be polished is improved is demonstrated.

The weight average molecular weight of the water-soluble polymer can be calculated in terms of polyethylene oxide using a gel permeation chromatography (GPC), for example.

The content of the water-soluble polymer in the polishing composition of this embodiment may be set to 0.0001% by mass or more, preferably 0.001% by mass or more, and more preferably 0.005% by mass or more. When the content of the water-soluble polymer is within the ranges mentioned above, an effect that the wettability of an object to be polished is improved is demonstrated. On the other hand, the content of the water-soluble polymer may be set to 1.0% by mass or less, preferably 0.1% by mass or less, more preferably 0.02% by mass or less, and still more preferably 0.01% by mass or less. When the content of the water-soluble polymer is within the ranges mentioned above, the dispersion stability of the polishing composition is improved.

A polymerization method of the water-soluble polymer is not particularly limited and, for example, reactions, such as polyaddition, polycondensation, addition condensation, and ionic polymerization, can be adopted. The water-soluble polymer may be a chain polymer, a sequential polymer, or a living polymer obtained by the reactions. Moreover, a plurality of kinds of water-soluble polymers different in the polymerization method may be used in combination.

### 4. Basic compound

The polishing composition of this embodiment may contain a basic compound. The basic compound gives a chemical action to the surface of an object to be polished, such as a silicon substrate, for chemically polishing (chemical etching). Thus, the polishing removal rate in polishing the object to be polished can be easily increased.

The type of the basic compound is not particularly limited and organic basic compounds may be acceptable and inorganic basic compounds, such as alkali metal hydroxide, alkali metal hydrogencarbonate, alkali metal carbonate, and ammonia, may be acceptable. These basic compounds may be used alone or in combination of two or more kinds thereof.

Specific examples of the basic compounds include hydroxides or salts of alkali metals or alkaline-earth metals, quaternary ammonium hydroxides or salts thereof, ammonia, amine, and the like. Specific examples of the alkali metals include potassium, sodium, and the like. Specific examples of the alkaline-earth metals include calcium, magnesium, and the like. Specific examples of the salts include carbonate, hydrogencarbonate, sulfate, acetate, and the like. Specific examples of the quaternary ammonium include tetramethylammonium, tetraethylammonium, tetrabutylammonium, and the like.

Specific examples of the hydroxides or salts of alkali metals include potassium hydroxide, potassium carbonate, potassium hydrogen carbonate, potassium sulfate, potassium acetate, potassium chloride, and the like. Specific examples of hydroxides or salts of alkaline-earth metals include calcium hydroxide and the like. Specific examples of the quaternary ammonium hydroxides or salts thereof include tetramethylammonium hydroxide, tetraethylammonium hydroxide, tetrabutylammonium hydroxide, and the like.

Specific examples of the amine include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, anhydrous piperazine, piperazine hexahydrate, 1-(2-aminoethyl)piperazine, N-methyl piperazine, guanidine, azoles, such as imidazole and triazole, and the like.

These basic compounds may be used alone or in combination of two or more kinds thereof.

Among the basic compounds, at least one kind selected from ammonia, ammonium salt, alkali metal hydroxide, alkali metal salt, and quaternary ammonium hydroxide is preferable. Further, at least one kind selected from ammonia, potassium hydroxide, sodium hydroxide, tetramethylammonium hydroxide, tetraethylammonium hydroxide, ammonium hydrogen carbonate, ammonium carbonate, potassium hydrogen carbonate, potassium carbonate, sodium hydrogen carbonate, and sodium carbonate is more preferable. Furthermore, at least one kind selected from ammonia, potassium hydroxide, sodium hydroxide, tetramethylammonium hydroxide, and tetraethylammonium hydroxide is still more preferable, at least either ammonia or tetramethylammonium hydroxide is yet still more preferable, and ammonia is the most preferable.

The content of the basic compound in the polishing composition of this embodiment may be set to 0.0001% by mass or more, preferably 0.001% by mass or more, and more preferably 0.005% by mass or more. When the content of the basic compound is within the ranges mentioned above, the polishing removal rate of an object to be polished by the polishing composition is improved. On the other hand, the content of the basic compound in the polishing composition may be set to 1.0% by mass or less, preferably 0.5% by mass or less, more preferably 0.1% by mass or less, still more preferably 0.05% by mass or less, and still more preferably 0.02% by mass or less. When the content of the basic compound is within the ranges mentioned above, excessive etching of an object to be polished is suppressed and the smoothness of a polished surface is improved.

### 5. pH of polishing composition

The pH of the polishing composition of this embodiment is not particularly limited and can be set to 9. 0 or more and 11.5 or less, preferably 9.5 or more and 11.0 or less, and more preferably 9.8 or more and 10.5 or less. When the pH is within the ranges mentioned above, an appropriate polishing removal rate is easily obtained. The pH of the polishing composition can be adjusted by adding a pH adjuster described later, for example.

### 6. Additives

In the polishing composition of this embodiment, in order to increase the performance, various additives, such as a pH adjuster, a surfactant, a chelating agent, and an antifungal agent, may be added, as necessary. However, it is preferable that an oxidant is not substantially contained.

### 6-1 pH adjuster

The pH value of the polishing composition of this embodiment can be adjusted by the addition of a pH adjuster. The polishing removal rate of an object to be polished, the dispersibility of abrasives, and the like can be controlled by the adjustment of the pH of the polishing composition. The addition amount of the pH adjuster is not particularly limited and may be adjusted as appropriate so that the polishing composition has a desired pH.

Specific examples of the pH adjuster include inorganic acids and organic acids, such as carboxylic acids and organic sulfuric acids. Specific examples of the inorganic acids include hydrochloric acid, sulfuric acid, nitric acid, fluoric acid, boric acid, carbonic acid, hypophosphorous acid, phosphorous acid, phosphoric acid, and the like. Specific examples of the carboxylic acids include formic acid, acetic acid, propionic acid, butyric acid, valeric acid, 2-methylbutyric acid, n-hexanoic acid, 3,3-dimethyl butyric acid, 2-ethyl butyric acid, 4-methylpentanoic acid, n-heptanoic acid, 2-methyl hexanoic acid, n-octanoic acid, 2-ethyl hexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, diglycollic acid, 2-furancarboxylic acid, 2,5-furandicarboxylic acid, 3-furancarboxylic acid, 2-tetrahydrofurancarboxylic acid, methoxy acetic acid, methoxy phenyl acetic acid, phenoxy acetic acid, and the like. Specific examples of the organic sulfuric acids include methanesulfonic acid, ethane sulfonic acid, isethionic acid, and the like. These acids may be used alone or in combination of two or more kinds thereof.

### 6-2 Surfactant

To the polishing composition of this embodiment, a surfactant may be added. Examples of the surfactant include anionic or nonionic surfactants and, among the above, the nonionic surfactants are preferable.

Specific examples of the nonionic surfactants include homopolymers of oxyalkylene, copolymers of a plurality of kinds of oxyalkylenes, and polyoxyalkylene adducts. Among the nonionic surfactants, the copolymers of a plurality of kinds of oxyalkylenes or the polyoxyalkylene adducts are preferable.

### 6-3 Chelating agent

To the polishing composition of this embodiment, a chelating agent may be added. The chelating agent captures metal impurity components in the polishing system to form a complex to thereby suppress metal contamination (particularly contamination by nickel or copper) of a silicon substrate.

Specific examples of the chelating agent include carboxylic acid-based chelating agents, such as gluconic acid, amine-based chelating agents, such as ethylenediamine, diethylenetriamine, and trimethyltetraamine, polyamino-polycarboxylic acid-based chelating agents, such as ethylenediaminetetraacetic acid, nitrilotriacetic acid, hydroxyethylethylenediaminetriacetic acid, triethylenetetraminehexaacetic acid, and diethylenetriaminepentaacetic acid, organic phosphonic acid-based chelating agents, such as 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1-diphosphonic acid, ethane-1,1,2-triphosphonic acid, methanehydroxyphosphonic acid, and 1-phosphonobutane-2,3,4-tricarboxylic acid, phenol derivatives, 1,3-diketones, and the like. Among the chelating agents, the organic phosphonic acid-based chelating agents, particularly ethylenediaminetetrakis(methylenephosphonic acid), are preferable. These chelating agents may be used alone or in combination of two or more kinds thereof.

### 6-4 Antifungal agent

To the polishing composition of this embodiment, an antifungal agent may be added. Specific examples of the antifungal agent include oxazoline, such as oxazolidine-2,5-dione.

### 6-5 Oxidant

It is preferable for the polishing composition of this embodiment not to substantially contain an oxidant. This is because, when the oxidant is contained in the polishing composition, the surface of an object to be polished (for example, silicon wafer) is oxidized by supplying the polishing composition to the object to be polished, so that an oxide film is generated, whereby the polishing time is prolonged. Specific examples of the oxidant as used herein include hydrogen peroxide (H₂O₂), sodium persulfate, ammonium persulfate, potassium permanganate, sodium dichloroisocyanurate, and the like.

The fact that the polishing composition is substantially free from the oxidant refers to at least intentionally not blending the oxidant. Therefore, polishing compositions inevitably containing a slight amount (For example, the molar concentration of the oxidant in the polishing compositions is 0.0005 mol/L or less, preferably 0.0001 mol/L or less, more preferably 0. 00001 mol/L or less, and particularly preferably 0. 000001 mol/L or less.) of the oxidant originating from raw materials, producing methods, and the like may be included in the concept of the polishing composition is substantially free from the oxidant referred to herein.

### 7. Water

The polishing composition of this embodiment may contain water. Water functions as a dispersion medium or a solvent for dispersing or dissolving the components (abrasives, water-soluble polymer, basic compound, additives, and the like) of the polishing composition. In order to avoid the inhibition of the work of each component contained in the polishing composition as much as possible, it is preferable to use water in which the total content of transition metal ions is 100 ppb or less, for example. For example, the purity of water can be increased by an operation, such as the removal of impurity ions using an ion-exchanged resin, the removal of particles by a filter, and distillation. Specifically, ion exchanged water, pure water, ultrapure water, distilled water, and the like are preferably used.

### 8. Method for producing polishing composition

A method for producing a polishing composition of this embodiment is not particularly limited, and the polishing composition can be produced by stirring and mixing abrasives, a water-soluble polymer, and, as desired, various additives, such as basic compounds, in water. The temperature in the mixing is not particularly limited and is preferably 10°C or more and 40°C or less and heating may be performed in order to increase the solution rate. The mixing time is also not particularly limited.

### 9. Polishing method and Method for polishing substrate

The use of the polishing composition of this embodiment is not particularly limited and the polishing composition can be used for preliminary polishing (stock polishing, secondary polishing) of an object to be polished, final polishing of mirror finishing the surface of an object to be polished after the preliminary polishing, and the like and can be preferably used particularly for final polishing a silicon substrate.

The polishing of an object to be polished using the polishing composition of this embodiment can be performed by a polishing machine and under polishing conditions for use in usual polishing. For example, a single-sided polishing machine and a double-sided polishing machine are usable.

For example, when a silicon substrate is used as an object to be polished and polishing is performed using a single-sided polishing machine, the silicon substrate is held using a holding fixture referred to as a carrier, a platen to which a polishing pad is stuck is pressed against one surface of the silicon substrate, and then the platen is rotated while supplying the polishing composition, whereby the one surface of the substrate is polished.

When a silicon substrate is polished using a double-sided polishing machine, the substrate is held using a holding fixture referred to as a carrier, a platen to which a polishing pad is stuck is pressed against each of both surfaces of the silicon substrate from both sides of the silicon substrate, and then the platens on the both sides are rotated while supplying the polishing composition, whereby the both surfaces of the substrate are polished.

In any case where either one of the polishing machines is used, the silicon substrate is polished by a physical action due to friction (friction of the polishing pad and the polishing composition and the silicon substrate) and a chemical action given to the silicon substrate by the polishing composition.

As the polishing pad, those containing various raw materials, such as polyurethane, nonwoven fabric, and suede, are usable. Those which are variously different in physical properties, such as hardness and thickness, besides the difference in raw materials, are usable. Furthermore, those containing abrasives and those containing no abrasives are all usable but those containing no abrasives are preferably used. Furthermore, those subjected to grooving to collect a liquid polishing composition are usable.

Furthermore, a polishing load (pressure loaded to an object to be polished) among the polishing conditions is not particularly limited and may be set to 5 kPa or more and 50 kPa or less, preferably 8 kPa or more and 30 kPa or less, and more preferably 10 kPa or more and 20 kPa or less. When the polishing load is within the ranges mentioned above, a sufficient polishing removal rate is demonstrated, so that the breakage of the object to be polished due to the load or the generation of defects, such as cracks, in the surface of the polishing target can be suppressed.

The relative velocity (linear velocity) between the polishing pad used for the polishing and the object to be polished, such as a silicon substrate, among the polishing conditions is not particularly limited and may be set to 10 m/min or more and 300 m/min or less and preferably 30 m/min or more and 200 m/min or less. When the relative velocity between the polishing pad and the object to be polished is within the ranges mentioned above, a sufficient polishing removal rate can be obtained. The breakage of the polishing pad due to the friction of the object to be polished can be suppressed and further the friction is sufficiently transmitted to the object to be polished and a so-called state where the object to be polished slides can be inhibited, so that the object to be polished can be sufficiently polished.

Furthermore, the supply amount of the polishing composition among the polishing conditions also varies depending on the type of the object to be polished, the type of the polishing machine, and the polishing conditions and may be an amount such that the polishing composition is uniformly supplied to the entire surface between the object to be polished and the polishing pad. When the supply amount of the polishing composition is small, the polishing composition is not supplied to the entire object to be polished or the polishing composition is dried and solidified to cause defects in the surface of the object to be polished in some cases. Conversely, when the supply amount of the polishing composition is large, there is a possibility that friction is sometimes blocked due to the excess polishing composition (particularly water), so that polishing is inhibited, besides not being economical.

The polishing composition of this embodiment can be collected after used for the polishing of an object to be polished to be reused for polishing of an obj ect to be polished. As one example of a method for reusing the polishing composition, a method is mentioned which includes collecting the polishing composition discharged from a polishing machine in a tank, and then circulating the same into the polishing machine again to use the same for polishing. When the polishing composition is used in recycle, the amount of the polishing composition discharged as a waste liquid can be reduced, and therefore an environmental load can be reduced. Moreover, the amount of the polishing composition to be used can be reduced, and therefore the production cost required for polishing an object to be polished can be reduced.

When the polishing composition of this embodiment is reused, the polishing composition may be reused after adding some or all of the abrasives, the water-soluble polymer, the basic compound, the additives, and the like, which were consumed or lost due to the fact that the polishing composition was used for polishing, as a composition regulator. As the composition regulator, one in which the abrasives, the water-soluble polymer, the basic compound, the additives, and the like are mixed at an arbitrary mixing ratio is usable. By additionally adding the composition regulator, the composition of the polishing composition is adjusted to a composition suitable for reuse, so that preferable polishing can be performed. The concentrations of the abrasives, the water-soluble polymer, the basic compound, and the additives contained in the composition regulator are arbitrary and are not particularly limited and may be adjusted as appropriate according to the tank size and the polishing conditions.

This embodiment gives an example of the present invention and the present invention is not limited to this embodiment. Moreover, this embodiment can be variously altered or modified and such altered and modified embodiments can also be included in the present invention. For example, the polishing composition of this embodiment may be a one-agent type or may be a multi-agent type, such as a two-agent type, in which some or all of the components of the polishing composition are mixed at an arbitrary ratio. In the polishing of an object to be polished, the object to be polished may be polished using an undiluted solution of the polishing composition of this embodiment as it is but may be polished using a dilution of the polishing composition obtained by diluting the undiluted solution with a diluent, such as water, 10 times or more.

### [EXAMPLES]

Hereinafter, the present invention is more specifically described with reference to Examples referring to Tables 1 and 2.

Abrasives containing silica having an average primary particle size of 25 nm or 35 nm, a water-soluble polymer, ammonia which is a basic compound, and ultrapure water were mixed so as to have concentrations given in Tables 1 and 2 to produce polishing compositions (slurry) of Examples 1 to 10 and Comparative Examples 1 to 11.

The type and the weight average molecular weight of the used water-soluble polymers are as given in Tables 1 and 2. "PVA-PVP" given in Tables 1 and 2 means a polyvinyl alcohol polyvinyl pyrrolidone random copolymer. Hereinafter, similarly,"HEC" means hydroxyethylcellulose, "PVA-PEO" means a polyvinyl alcohol polyethylene oxide graft copolymer, "PACMO" means polyacryloyl morpholine, "PAA" means polyacrylic acid, "PNVA" means poly-N-vinyl acetamide, "PVI" means polyvinyl imidazole, "PVP" means polyvinyl pyrrolidone, and "PVA" means polyvinyl alcohol.

The adsorption ratios to the silica of the water-soluble polymer used for the polishing compositions of Examples 1 to 10 and Comparative Examples 1 to 11 when the pH was 10.0 and the adsorption ratios to the silica when the pH was 10.4 are as given in Tables 1 and 2.

A method for measuring the adsorption ratio is as follows. First, a method for measuring the adsorption ratio to the silica of the water-soluble polymer when the pH is 10.0 is described.
(1) An undiluted solution of a first standard solution in which the concentration of silica having an average primary particle size of 35 nm was 9.6% by mass, the concentration of a water-soluble polymer was 0.25% by mass, the concentration of ammonia was 0.08% by mass, and the balance was ion exchanged water was prepared. Then, the undiluted solution of a first standard solution was diluted with ion exchanged water to 20 times in terms of volume ratio to prepare a first standard solution having a pH of 10.0. When an aqueous solution of the water-soluble polymer is acidic (for example, polyacrylic acid), the pH of the aqueous solution of the water-soluble polymer is adjusted to 7.0 with ammonia before mixed with silica and ammonia to be formed into the undiluted solution of a first standard solution, and thereafter mixed with silica and ammonia to be formed into the undiluted solution of a first standard solution.
(2) The total organic carbon concentration (TOC value) of the first standard solution is measured, and then the obtained TOC value of the first standard solution is defined as the total carbon concentration (I) of the water-soluble polymer contained in the first standard solution. For the measurement of the TOC value, a total organic carbon meter TOC-5000A manufactured by Shimadzu Corporation is usable, for example.
(3) Next, the first standard solution was subjected to centrifugal separation treatment for 30 minutes at a rotational speed of 20000 rpm to be separated into a precipitate containing the silica and a supernatant liquid free from the silica, and then the TOC value of the supernatant liquid was measured using the total organic carbon meter TOC-5000A manufactured by Shimadzu Corporation, for example. Then, the TOC value of the supernatant liquid was subtracted from the TOC value of the first standard solution, whereby the carbon concentration (II) of the water-soluble polymer adsorbed to the silica was calculated. Furthermore, the ratio (percentage) of the carbon concentration (II) of the water-soluble polymer adsorbed to the silica to the total carbon concentration (I) of the water-soluble polymer contained in the first standard solution was calculated according to (II) / (I) × 100, and then the obtained numerical value was defined as the adsorption ratio to the silica of the water-soluble polymer when the pH was 10.0.

Next, a method for measuring the adsorption ratio to the silica of the water-soluble polymer when the pH is 10.4 is described.
(1) An undiluted solution of a second standard solution in which the concentration of silica having an average primary particle size of 35 nm was 9.6% by mass, the concentration of a water-soluble polymer was 0.25% by mass, the concentration of ammonia was 0.5% by mass, and the balance was ion exchanged water was prepared. Then, the undiluted solution of a second standard solution was diluted with ion exchanged water to 20 times in terms of volume ratio to prepare a second standard solution having a pH of 10.4. When an aqueous solution of the water-soluble polymer is acidic (for example, polyacrylic acid), the pH of the aqueous solution of the water-soluble polymer is adjusted to 7.0 with ammonia before mixed with silica and ammonia to be formed into the undiluted solution of a second standard solution, and thereafter mixed with silica and ammonia to be formed into the undiluted solution of a second standard solution.
(2) The total organic carbon concentration (TOC value) of the second standard solution is measured, and then the obtained TOC value of the second standard solution is defined as the total carbon concentration (III) of the water-soluble polymer contained in the second standard solution. For the measurement of the TOC value, the total organic carbon meter TOC-5000A manufactured by Shimadzu Corporation is usable, for example.
(3) Next, the second standard solution was subjected to centrifugal separation treatment for 30 minutes at a rotational speed of 20000 rpm to be separated into a precipitate containing the silica and a supernatant liquid free from the silica, and then the TOC value of the supernatant liquid was measured using the total organic carbon meter TOC-5000A manufactured by Shimadzu Corporation, for example. Then, the TOC value of the supernatant liquid was subtracted from the TOC value of the second standard solution, whereby the carbon concentration (IV) of the water-soluble polymer adsorbed to the silica was calculated. Furthermore, the ratio (percentage) of the carbon concentration (IV) of the water-soluble polymer adsorbed to the silica to the total carbon concentration (III) of the water-soluble polymer contained in the second standard solution was calculated according to (IV) / (TII)×100, and then the obtained numerical value was defined as the adsorption ratio to the silica of the water-soluble polymer when the pH was 10.4.

**[Table 1]**

| | Silica | | Water-soluble polymer | | | | | Basic compound | | Evaluation results | |
|---|---|---|---|---|---|---|---|---|---|---|---|
| | Average primary particle size (nm) | Concentration (% by mass) | Type | Weight average molecular weight | Adsorption ratio at pH of 10.0 | Adsorption ratio at pH of 10.4 | Concentration (% by mass) | Type | Concentration (% by mass) | Haze | LPD-N |
| Ex. 1 | 35 | 0.460 | PACMO | 32500 | 90 | 5 | 0.0125 | Ammonia | 0.010 | 65 | 33 |
| Ex. 2 | 35 | 0.460 | HEC | 25000 | 80 | 10 | 0.0180 | Ammonia | 0.010 | 50 | 12 |
| Ex. 3 | 35 | 0.236 | PVA-PEO | 20000 | 65 | 20 | 0.0150 | Ammonia | 0.011 | 44 | 51 |
| Ex. 4 | 35 | 0.460 | PVA-PVP | 14000 | 20 | 1 | 0.0025 | Ammonia | 0.010 | 37 | 46 |
| Ex. 5 | 35 | 0.460 | PVA-PVP | 14000 | 20 | 1 | 0.0050 | Ammonia | 0.010 | 40 | 21 |
| Ex. 6 | 35 | 0.460 | PVA-PVP | 14000 | 20 | 1 | 0.0063 | Ammonia | 0.010 | 42 | 11 |
| Ex. 7 | 35 | 0.460 | PVA-PVP | 14000 | 20 | 1 | 0.0075 | Ammonia | 0.010 | 43 | 8 |
| Comp. Ex. 1 | 35 | 0.460 | PVP | 45000 | 90 | 70 | 0.0180 | Ammonia | 0.010 | 180 | Unmeasurable |
| Comp. Ex. 2 | 35 | 0.460 | PVA | 13500 | 1 | 1 | 0.0125 | Ammonia | 0.010 | 100 | 100 |

**[Table 2]**

| | Silica | | Water-soluble polymer | | | | | Basic compound | | Evaluation results | |
|---|---|---|---|---|---|---|---|---|---|---|---|
| | Average primary particle size (nm) | Concentration (% by mass) | Type | Weight average molecular weight | Adsorption ratio at pH of 10.0 | Adsorption ratio at pH of 10.4 | Concentration (% by mass) | Type | Concentration (% by mass) | Haze | LPD-N |
| Ex. 8 | 25 | 0.169 | PACMO | 325000 | 90 | 5 | 0.0125 | Ammonia | 0.011 | 41 | 8 |
| Ex. 9 | 25 | 0.169 | PVA-PEO | 20000 | 65 | 20 | 0.0075 | Ammonia | 0.011 | 35 | 7 |
| Ex. 10 | 25 | 0.169 | PVA-PEO | 20000 | 65 | 20 | 0.0150 | Ammonia | 0.011 | 33 | 23 |
| Comp. Ex. 3 | 25 | 0.083 | PAA | 10000 | 5 | 5 | 0.0035 | Ammonia | 0.005 | Unpolishable | Unpolishable |
| Comp. Ex. 4 | 25 | 0.083 | PAA | 10000 | 5 | 5 | 0.0050 | Ammonia | 0.005 | Unpolishable | Unpolishable |
| Comp. Ex. 5 | 25 | 0.169 | PAA | 10000 | 5 | 5 | 0.0075 | Ammonia | 0.011 | Unpolishable | Unpolishable |
| Comp. Ex. 6 | 25 | 0.083 | PNVA | 300000 | 90 | 70 | 0.0025 | Ammonia | 0.005 | 546 | Unmeasurable |
| Comp. Ex. 7 | 25 | 0.083 | PNVA | 300000 | 90 | 70 | 0.0050 | Ammonia | 0.005 | 287 | Unmeasurable |
| Comp. Ex. 8 | 25 | 0.083 | PVI | 17100 | 90 | 90 | 0.0025 | Ammonia | 0.005 | Unpolishable | Unpolishable |
| Comp. Ex. 9 | 25 | 0.083 | PVI | 17100 | 90 | 90 | 0.0050 | Ammonia | 0.005 | 216 | Unmeasurable |
| Comp. Ex. 10 | 25 | 0.083 | PVI | 17100 | 90 | 90 | 0.0063 | Ammonia | 0.005 | 361 | Unmeasurable |
| Comp. Ex. 11 | 25 | 0.083 | PVI | 17100 | 90 | 90 | 0.0013 | Ammonia | 0.005 | 210 | Unmeasurable |

Next, a silicon wafer was polished under the following polishing conditions using the polishing compositions of Examples 1 to 10 and Comparative Examples 1 to 11. The diameter of the silicon wafer is 300 mm. The conductive type is a P-type, the crystal orientation is <100>, and the resistivity is 0.1 Ω·cm or more and less than 100 Ω·cm.

### (Polishing conditions)

Polishing machine: Polishing machine manufactured by Okamoto Machine Tool Works, Ltd., Type "PNX332B"
Polishing pad: "POLYPAS27NX" manufactured by Fujibo Ehime Co., Ltd.
Polishing pressure: 15 kPa
Rotational speed of platen: 30 min⁻¹
Rotational speed of head (carrier) : 30 min⁻¹
Polishing time: For 120 seconds
Polishing composition supply flow rate: 2 L/min (Used in the one-way)
Temperature of polishing composition: 20°C

Then, the silicon wafer after the polishing was immersed in a cleaning liquid for 6 minutes to be cleaned (SC-1 cleaning), and then subjected to ultrasonic treatment using an ultrasonic oscillator in the state of being immersed in deionized water. Then, the moisture was removed using 2-propanol for drying. The cleaning liquid is a mixed liquid obtained by mixing ammonia water having a concentration of 29% by mass, a hydrogen peroxide solution having a concentration of 31% by mass, and deionized water at a volume ratio of 1:3:30.

The silicon wafer after the polishing, the cleaning, and the drying were completed was measured for the haze and the number of defects using a wafer defect tester Surfscan SP2 (Trade Name) manufactured by KLA-Tencor Ltd. The number of defects is the number of defects (LPD-N) having a size of 61 nm or more present in the surface of the silicon wafer. The measurement results are given in Tables 1 and 2.

The numerical values of the haze and the number of defects given in Tables 1 and 2 are given by relative values when the haze and the number of defects of Comparative Example 2 was set to 100. Moreover, the "Unpolishable" in Tables 1 and 2 means that the polishing became impossible because the polishing machine vibrated due to high friction between the silicon wafer and the polishing pad. The "Unmeasurable" means that the measurement result overflowed due to an excessively large LPD-N.

As is understood from Tables 1 and 2, the polishing compositions of Examples 1 to 10 contained the water-soluble polymer in which the adsorption ratio to the silica when the pH is 10.0 is 10% or more and the adsorption ratio to the silica when the pH is 10.4 is 65% or less, and therefore the silicon wafer had a low haze and had few LPD-Ns.

## Claims

1. A polishing composition comprising:
Abrasives; and
a water-soluble polymer, wherein
the abrasives are silica,
the abrasives have an average secondary particle size of 10 nm or more and 150 nm or less,
the abrasives have an average primary particle size of 10 nm or more and 30 nm or less,
the water-soluble polymer contains one selected from a copolymer containing polyvinyl pyrrolidone in a part of the structure or a polymer having polyoxyalkylene structure,
a weight average molecular weight of the water-soluble polymer is 1000 or more and 1000000 or less,
a content of the water-soluble polymer is 0.0001% by mass or more and 1.0% by mass or less,
the polishing composition further contains a basic compound selected from hydroxides or salts of alkali metals or alkaline-earth metals, quaternary ammonium hydroxides or salts thereof, ammonia or amine,
a content of the basic compound in the polishing composition is 0.0001% by mass or more and 1.0% by mass or less, and
the water-soluble polymer satisfies following two conditions (A) and (B):
Condition (A): in a first standard solution containing silica having an average primary particle size of 35 nm, the water-soluble polymer, ammonia, and water, in which a concentration of the silica is 0.48% by mass, a concentration of the water-soluble polymer is 0.0125% by mass, and a pH is 10.0, an adsorption ratio defined as a ratio of an amount of the water-soluble polymer adsorbed to the silica to a total amount of the water-soluble polymer contained in the first standard solution is 10% or more; and
Condition (B): in a second standard solution containing silica having an average primary particle size of 35 nm, the water-soluble polymer, ammonia, and water, in which the concentration of the silica is 0.48% by mass, the concentration of the water-soluble polymer is 0.0125% by mass, and the pH is 10.4, the adsorption ratio defined as a ratio of the amount of the water-soluble polymer adsorbed to the silica to the total amount of the water-soluble polymer contained in the second standard solution is 65% or less.

2. The polishing composition according to Claim 1, wherein the water-soluble polymer is a chain polymer, a sequential polymer, or a living polymer.

3. The polishing composition according to Claim 1, wherein the copolymer containing polyvinyl pyrrolidone in a part of the structure has a weight average molecular weight of 14000.

4. The polishing composition according to any one of Claims 1 to 3, wherein the polishing composition is used for polishing silicon.

5. A method for polishing a silicon substrate comprising polishing a silicon substrate using the polishing composition according to any one of Claims 1 to 4.

## Patentansprüche

1. Polierzusammensetzung, umfassend:
Schleifmittel; und
ein wasserlösliches Polymer, wobei
die Schleifmittel Kieselerde sind,
die Schleifmittel eine durchschnittliche Sekundärteilchengröße von 10 nm oder mehr und 150 nm oder weniger besitzen,
die Schleifmittel eine durchschnittliche Primärteilchengröße von 10 nm oder mehr und 30 nm oder weniger besitzen,
das wasserlösliche Polymer eines enthält, ausgewählt aus einem Copolymer, enthaltend Polyvinylpyrrolidon in einem Teil der Struktur, oder einem Polymer, besitzend eine Polyoxyalkylenstruktur,
ein gewichtsgemitteltes Molekulargewicht des wasserlöslichen Polymers 1000 oder mehr und 1000000 oder weniger ist,
ein Gehalt des wasserlöslichen Polymers 0,0001 Massenprozent oder mehr und 1,0 Massenprozent oder weniger ist,
die Polierzusammensetzung weiter eine basische Verbindung enthält, ausgewählt aus Hydroxiden oder Salzen von Alkali- oder Erdalkalimetallen, quaternären Ammoniumhydroxiden oder deren Salzen, Ammoniak oder Amin,
ein Gehalt der basischen Verbindung in der Polierzusammensetzung 0,0001 Massenprozent oder mehr und 1,0 Massenprozent oder weniger ist, und
das wasserlösliche Polymer die beiden folgenden Bedingungen (A) und (B) erfüllt:
Bedingung (A): in einer ersten Standardlösung, enthaltend Kieselerde, besitzend eine durchschnittliche Primärteilchengröße von 35 nm, das wasserlösliche Polymer, Ammoniak und Wasser, in der eine Konzentration der Kieselerde 0,48 Massenprozent, eine Konzentration des wasserlöslichen Polymers 0,0125 Massenprozent und ein pH-Wert 10,0 ist, ist ein Adsorptionsverhältnis, definiert als ein Verhältnis einer Menge des an die Kieselerde adsorbierten wasserlöslichen Polymers zu einer Gesamtmenge des in der ersten Standardlösung enthaltenen wasserlöslichen Polymers, 10 % oder mehr; und
Bedingung (B): in einer zweiten Standardlösung, enthaltend Kieselerde, besitzend eine durchschnittliche Primärteilchengröße von 35 nm, das wasserlösliche Polymer, Ammoniak und Wasser, in der eine Konzentration der Kieselerde 0,48 Massenprozent, eine Konzentration des wasserlöslichen Polymers 0,0125 Massenprozent und ein pH-Wert 10,4 ist, ist ein Adsorptionsverhältnis, definiert als ein Verhältnis einer Menge des an die Kieselerde adsorbierten wasserlöslichen Polymers zu einer Gesamtmenge des in der zweiten Standardlösung enthaltenen wasserlöslichen Polymers, 65 % oder weniger.

2. Die Polierzusammensetzung nach Anspruch 1, wobei das wasserlösliche Polymer ein Kettenpolymer, ein sequentielles Polymer oder ein lebendes Polymer ist.

3. Die Polierzusammensetzung nach Anspruch 1, wobei das Copolymer, enthaltend Polyvinylpyrrolidon in einem Teil der Struktur, ein gewichtsgemitteltes Molekulargewicht von 14000 besitzt.

4. Die Polierzusammensetzung nach irgendeinem der Ansprüche 1 bis 3, wobei die Polierzusammensetzung zum Polieren von Silizium verwendet wird.

5. Verfahren zum Polieren eines Siliziumsubstrats, umfassend das Polieren eines Siliziumsubstrats unter Verwenden der Polierzusammensetzung nach irgendeinem der Ansprüche 1 bis 4.

## Revendications

1. Composition de polissage comprenant :
des abrasifs ; et
un polymère hydrosoluble, dans laquelle
les abrasifs sont de la silice,
les abrasifs ont une taille moyenne de particule secondaire de 10 nm ou plus et 150 nm ou moins,
les abrasifs ont une taille moyenne de particule primaire de 10 nm ou plus et 30 nm ou moins,
le polymère hydrosoluble contient l'un parmi un copolymère contenant de la polyvinylpyrrolidone dans une partie de la structure ou un polymère ayant une structure polyoxyalkylène,
une masse moléculaire moyenne en poids du polymère hydrosoluble est de 1000 ou plus et 1 000 000 ou moins,
une teneur du polymère hydrosoluble est de 0,0001 % en masse ou plus et 1,0 % en masse ou moins,
la composition de polissage contient en outre un composé basique choisi parmi des hydroxydes ou des sels de métaux alcalins ou de métaux alcalino-terreux, des hydroxydes d'ammonium quaternaire ou des sels de ceux-ci, de l'ammoniaque ou une amine,
une teneur du composé basique dans la composition de polissage est de 0,0001 % en masse ou plus et 1,0 % en masse ou moins, et
le polymère hydrosoluble satisfait aux deux conditions (A) et (B) suivantes :
Condition (A) : dans une première solution étalon contenant de la silice ayant une taille moyenne de particule primaire de 35 nm, le polymère hydrosoluble, de l'ammoniaque et de l'eau, dans laquelle une concentration de la silice est de 0,48 % en masse, une concentration du polymère hydrosoluble est de 0,0125 % en masse et un pH est égal à 10,0, un rapport d'adsorption défini en tant que rapport d'une quantité du polymère hydrosoluble adsorbé sur la silice à une quantité totale du polymère hydrosoluble contenu dans la première solution étalon est de 10 % ou plus ; et
Condition (B) : dans une seconde solution étalon contenant de la silice ayant une taille moyenne de particule primaire de 35 nm, le polymère hydrosoluble, de l'ammoniaque et de l'eau, dans laquelle la concentration de la silice est de 0,48 % en masse, la concentration du polymère hydrosoluble est de 0,0125 % en masse et le pH est égal à 10,4, le rapport d'adsorption défini en tant que rapport de la quantité du polymère hydrosoluble adsorbé sur la silice à la quantité totale du polymère hydrosoluble contenu dans la seconde solution étalon est de 65 % ou moins.

2. Composition de polissage selon la revendication 1, dans laquelle le polymère hydrosoluble est un polymère à chaîne, un polymère séquentiel, ou un polymère vivant.

3. Composition de polissage selon la revendication 1, dans laquelle le copolymère contenant de la polyvinylpyrrolidone dans une partie de la structure a une masse moléculaire moyenne en poids de 14 000.

4. Composition de polissage selon l'une quelconque des revendications 1 à 3, la composition de polissage étant utilisée pour polir du silicium.

5. Procédé de polissage d'un substrat de silicium, comprenant le polissage d'un substrat de silicium à l'aide de la composition de polissage selon l'une quelconque des revendications 1 à 4.
